Europäisches Patentamt

European Patent Office

Office européen des brevets

(11) Publication number: **0 408 768 A1**

# EUROPEAN PATENT APPLICATION
## published in accordance with Art. 158(3) EPC

(21) Application number: 90902671.8

(22) Date of filing: 05.02.90

(86) International application number:
PCT/JP90/00138

(87) International publication number:
WO 90/09035 (09.08.90 90/19)

(51) Int. Cl.⁵: **H01L 21/60**

(30) Priority: 06.02.89 JP 125677/89
09.03.89 JP 155220/89

(43) Date of publication of application:
23.01.91 Bulletin 91/04

(84) Designated Contracting States:
DE FR GB IT NL

(71) Applicant: **FURUKAWA DENKI KOGYO KABUSHIKI KAISHA**
**6-1 Marunouchi 2-chome**
**Chiyoda-ku Tokyo(JP)**

(72) Inventor: **OHTANI, Kenichi**
**421-6, Yamashita Hiratsuka-shi**
**Kanagawa 254(JP)**

(74) Representative: **Ahner, Francis et al**
**CABINET REGIMBEAU 26, avenue Kléber**
**F-75008 Paris(FR)**

(54) **CHIP CARRIER.**

(57) This invention relates to a chip carrier for mounting a semiconductor device chip (6) in which a predetermined metal wiring (1) is formed on the surface of a flexible film member (2), wherein the film member (2) of a first region that includes an inner lead portion (1a) of the metal wiring (1) and that surrounds the region on which the chip (6) is mounted has a thickness less than the second thickness of the region surrounding the first region.

## FIG.1

Xerox Copy Centre

# CHIP CARRIER

## Technical Field

The present invention relates to a chip carrier which is used for connecting the terminal portions of a semiconductor device chip, such as, an IC or LSI to the terminal portions of a container (so-called package) or circuit board.

## Background Art

In the past, a semiconductor device chip has been connected to the lead frame of a package for device chip containing purposes or the terminals of a circuit board for chip mounting purposes by means of bonding wires or a chip carrier such as a tape carrier or patch. The classification by use of the bonding wires and the chip carrier is dependent on the pin pitch of the semiconductor device chip so that it has been the general practice to use the chip carrier when the pitch is for example less than 200 to 300 $\mu$m.

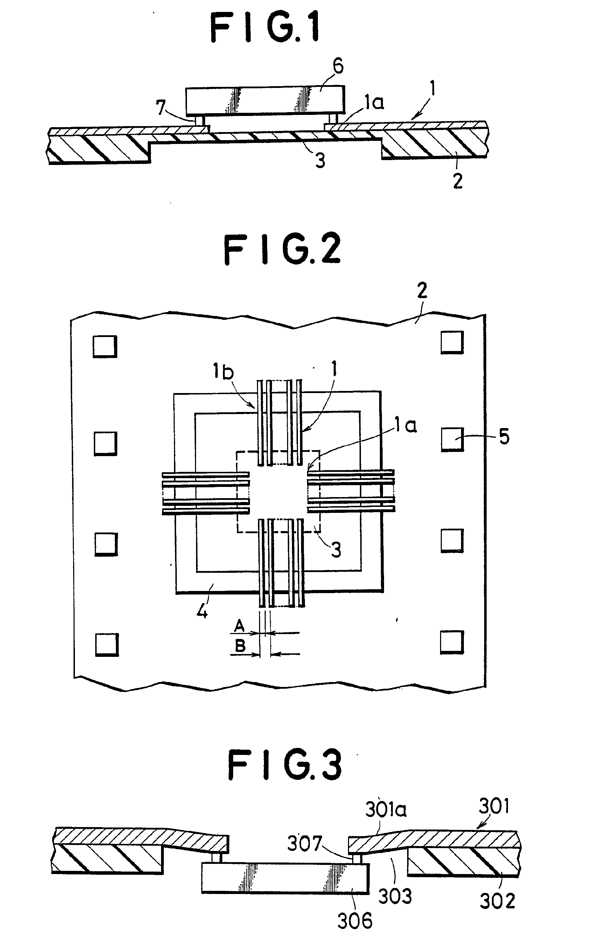

Fig.3 shows a conventional tape carrier in which a flexible tape 302 made for example of a polyimide film or a polyester film includes a plurality of device holes 303 which are formed at a given pitch and into which semiconductor device chips 306 are to be mounted and formed on one surface of the flexible tape 302 for each device hole

- 1 -

303 is a given metal wiring 301 having inner lead portions 301a and radially arranged along the periphery of the opening of each device hole 303.

As shown in Fig.3, the inner lead portions 301a are extended over the opening of the device hole 303 (i.e., the so-called overhanging structure) so that when the semiconductor device chip 306 is mounted in the device hole 303, each of the inner lead portions 301a is bonded to one of bumps 307 of the semiconductor device chip 306.

Then, with the recent remarkable trend toward higher density integration of semiconductor device chips, a progress has been made toward increasing the number of input and output pins and presently semiconductor device chips having pin pitches of less than $100 \mu m$ have reached the stage of practical use.

However, it is extremely difficult to manufacture chip carriers, e.g., tape carriers having very fine inner lead portions corresponding to the semiconductor device chips having such extremely narrow pin pitches.

In other words, generally the conventional method of forming the metal wiring of a chip carrier comprises depositing a copper foil of about $35 \mu m$ or applying copper foil strip to a flexible film member and then etching the copper foil or foil strip, or forming a layer of catalytic activity to electroless plating in a given pattern on the surface of a flexible film member, and then applying copper plating to thereon, and the following problems are encounted in the provision of an extremely small pin pitch.

In the case of the former etching method, if, for example, the pin pitch is 70 $\mu$m, then the width of each wiring conductor becomes about 35 $\mu$m so that in the case of the copper foil layer of 36 $\mu$m thick, the ratio of the conductor width to the conductor thickness becomes less than 1 and in such case there is the occurrence of remarkable side etching thus causing the sectional shape of each wiring conductor to become trapezoidal.

Also, in the case of the latter plating method, there is the possibility of causing lumps to protrude from the built-up plating to establish a short-circuit between the wiring conductors and the size of such lumps becomes for example as large as about 20 $\mu$m.

In order to overcome these problems, it is desirable to decrease the thickness of the metal wiring in either of these methods. In other words, the side etching does not proceed much and wiring conductors of substantially rectangular in section are produced if the thickness of the layer of copper foil is thin in the method by etching, whereas the growth of lumps is reduced and the danger of occurrence of short-circuit is reduced if the plating thickness is small even in the case of the method by plating.

However, since the inner lead portions of the conventional metal wiring are of the overhanging structure extending over the opening of each device hole as mentioned previously, the metal wiring must withstand all by itself the application of pressure during the bonding of the

- 3 -

semiconductor device chip. While it is considered that the withstand applied pressure (hereinafter referred to as a "finger strength") must be from 5 to 15g in such case, if, for example, the layer of copper foil is reduced in thickness thus producing copper foil wiring conductor of

$25\mu$m wide and $18\mu$m thick, the resulting finger strength is 12g and the metal wiring of such reduced thickness cannot withstand the bonding of the semiconductor device chip.

The present invention has been made in view of these circumstances and it is an object of the invention to provide a chip carrier which ensures finer metal wirings, has a satisfactory finger strength and is excellent in bonding processability and also to combine this chip carrier and semiconductor device chips of high-density integration thereby making easy the utilization of the semiconductor device chips of high-density integration.

Disclosure of Invention

In accordance with the present invention, instead of forming device holes of the conventional type in a chip carrier, each region corresponding to a plurality of inner lead portions of a metal wiring and adapted to mount a semiconductor device chip thereon (that is, corresponding to a conventional device hole perforated portion) is designated as a first region, and formed in the first region is a film portion having a thickness less than the second thickness of a second region surrounding the first region thereby

- 4 -

accomplishing the foregoing objects by virtue of the thin-film portion of the first region.

In other words, in accordance with the present invention the inner lead portions of the metal wiring are not of the overhanging structure as in the past but are formed on the thin-film portion formed in a first region so as to be supported and fixed in place by the same and therefore the metal wiring can satisfactorily withstand the application of heat and pressure during the bonding operation even if the thickness of the metal wiring is reduced. As a result, the metal wiring can be reduced in thickness without decreasing the finger strength and this makes possible the provision of such superfine metal wiring which has never been possible in the past.

Also, in accordance with the present invention, by virtue of the fact the thickness of a flexible film portion is reduced in a first region corresponding to each of the conventional device hole portions, the thermal stresses produced due to the difference in thermal expansion coefficient between the thin-film portion and the metal wiring are reduced and there is less danger of the inner lead portions being subjected to deformation, etc., due to the application of heat during the bonding operation.

In addition, the inner lead portions are fixedly disposed on the thin-film portion so that there is less danger of troubles, such as, the inner lead portions being deformed due to for example their contact with any other object and the occurrence of contacting (short-circuiting) between the adjoining inner lead portions due to for example
disarrangement of their forward ends and the orderly
arranged condition of the inner lead portions is maintained
from the time of manufacture of the chip carrier until the
time of the bonding of the semiconductor device chip.

Further, since the second thickness of the second
region is made greater than the first thickness, the
required film strength for the chip carrier can be
maintained. Particularly, where a tape carrier is used for
the chip carrier, even if the flexible film member comprises
a long tape member and a plurality of chip mounting portions
are formed, the required strength for the tape member can be
maintained by the second thickness and therefore there is
the effect of simplifying the tape take-up operation and
other handling operations which are performed during the
time of manufacture of the tape until the bonding of the
semiconductor device chips to the tape carrier.

Still further, where there is the opening in the inner
region of the forward ends of the inner lead portions (a
region A), this opening is adapted to function as the
conventional device hole and also the flexible film portion
(a region B) of the region over which the conventional inner
lead portions hang (the portion of the first region without
the region A) is reduced in thickness so as to ensure a
given finger strength, with the result that the thermal
stresses produced due to the difference in thermal expansion
coefficient between this thin-film portion and the metal
wiring is reduced and there is less danger of the inner lead portions being deformed by the application of heat during the bonding operation as in the case of the previously mentioned invention.

Still further, since the opening is formed in the region A and no flexible film member is formed, there is the advantage of preventing the impurity ions contained in the flexible film member from emigrating to the semiconductor device thereby destroying it.

In addition, the third region corresponding to a plurality of outer lead portions of the wiring may be devoid of the flexible film portion or may be formed with the same thin-film portion as the first region as occasion demands.

This is the problem in cases where a semiconductor device chip is mounted on the above-mentioned chip carrier thus forming a semiconductor device and then the semiconductor device is connected to the terminal portions of an external circuit assembly, that is, where the semiconductor device is electrically connected to the terminals through direct bonding process by a mechanical working apparatus or the like, it is desirable to form a thin-film portion in the third region in order to increase the finger strength of the outer lead portions. Also, where it is sold as an ordinary semiconductor device, if, for example, the arrangement of the terminals of the external circuit assembly differs from the arrangement of the outer lead portions or the bonding positions are on the back surface side, it is desirable to form no flexible film member in the third region in consideration of the bending properties, electrical bonding conditions, etc., of the outer lead portions.

Also, the first and third regions may be combined so as to form the thin-film portion throughout the whole region including the metal wiring portion and its surrounding region may be formed into a thick-section portion as the second region.

While there are no particular limitations to the manufacturing method of the chip carrier according to the present invention, it is only necessary that finally a first region of a flexible firm member is formed with a thin-film portion thinner than a second region surrounding the first region.

For instance, it can be manufactured by the following methods.

To begin with, a film of metal (e.g., copper, chromium or nickel) having a thickness between 0.1 and 1 $\mu$m is formed by a spatter evaporation process on one surface of a flexible film having a thickness of about 10 to 200 $\mu$m and made of a material having excellent heat resisting properties, e.g., polyimide, polyphenylene sulfide, polyethylene telephthalate or liquid crystal polymer.

Then, the metal wiring is formed by further applying, if necessary, copper plating to form a layer of metal foil mainly composed of copper and having a thickness of 1 to 20 $\mu$m and subjecting the layer of metal foil to etching, or by masking the unnecessary portions after the formation of the metal foil layer (the masking is made with a negative pattern), applying copper plating to the metal foil layer and then subjecting the metal foil layer to flash etching.

Thereafter, if an opening is to be formed, the flexible film member is removed with respect to a region A which is a region surrounded by the inner lead portions of the metal wiring and which is on the inner side of the forward ends of the inner lead portions, thereby forming a device hole. It is to be noted that while the functional effects of the present invention can be fully obtained if the region on the inner side of the forward ends of the inner lead portions is such that the distance from the forward ends of the inner lead portions is about 5mm or less, it is desirable that the distance should more preferably be about 2mm or less from the forward ends of the inner lead portions.

Thereafter, with respect to the first region corresponding to the inner lead portions of the metal wiring or the region left after removing a region A from the first region, the thickness of the flexible film member is reduced from the side where the metal winding is not formed thereby forming a thin-film portion in the first region.

It is to be noted that where the flexible film member is removed entirely or a thin-film portion is formed with respect to a third region corresponding to the outer lead portions of the metal wiring, this can be performed in conformity with the above-mentioned methods.

Here, as regards the methods of reducing the thickness of the flexible film member made of a high molecular film, there is known for example plasma etching as the dry etching method. According to this method, a gas which is plasma activated by an ECR plasma or the like is sprayed to the surface to be etched so that the high-molecular film of this portion is removed and a thin-film portion is formed.

On the other hand, where the flexible film member is a polyimide film, a desirable result can be obtained by means of wet etching using a mixed solution of hydrazine and ethylenediamine, a solution prepared by dissolving an alkaline chemical such as potassium hydroxide in ethanol or water or the like.

In this case, the thickness of the thin-film portion formed in the first region of the flexible film member should preferably be maintained greater than about $5 \mu m$ for the purpose of ensuring a satisfactory finger strength and also it should preferably be equivalent to or less than the thickness of the metal wiring in order to prevent the inner lead portions from being deformed by thermal stresses. For instance, where the flexible film member comprises a polyimide film, the thickness should preferably by in the range of 5 to $25 \mu m$ from the finger strength point of view.

As described hereinabove, in accordance with the present invention the inner lead portions of the chip carrier are reinforced by the thin-film portion of the flexible film member so that even in such cases where the thickness of the metal wiring is considerably thin as compared with the conventional thicknesses, there is less danger of the inner lead portions being folded down under the application of heat and pressure during the bonding process or the inner lead portions being deformed by thermal stresses and the bonding processability is extremely excellent.

Also, since the inner lead portions are fixedly attached onto the thin-film portion of the flexible film, the orderly arrangement of the inner lead portions are always maintained and this is advantageous from the standpoint of ensuring positive bonding in cases where the pin pitch of the inner lead portions is extremely narrow.

Then, in accordance with the present invention it is possible to realize a chip carrier, e.g., a tape carrier having extremely fine inner lead portions which have never been possible in the past, so that the invention can deal with the mounting of semiconductor device chips having extremely narrow pin pitches and the invention has a great utility in the light of the recent progress toward higher-density integration of semiconductor device chips.

Further, by using this chip carrier in combination with semiconductor device chips to produce products as semiconductor devices, it is possible to reduce the labor and expenses in the manufacturing stage and also to reduce the occurrence of rejects, thereby reducing the product cost.

In addition, in the case of the chip carrier having an opening within the first region, the opening can be used as a device hole of the conventional type and it is also effective in preventing a semiconductor device chip from being destroyed due to the effect of the impurity ions contained in the flexible film member.

Further, in the case of the chip carrier formed with a thin-film portion for the outer lead portions, the bonding processability is extremely excellent when connecting the chip to the terminals of an external circuit assembly or the like.

Brief Description of Drawings

Fig.1 shows a partial section of a chip carrier according to a first embodiment of the present invention,

Fig.2 shows a partial plan of the first embodiment applied to a tape carrier,

Fig.3 shows a partial section of a conventional chip carrier,

Fig.4 shows a partial section of a chip carrier according to a second embodiment of the present invention,

Fig.5 shows a partial plan of the second embodiment applied to a tape carrier, and

Figs.6, 7, 8 and 9 show in partial section the constructions of chip carriers according to another embodiments of the present invention.

Best Mode for Carrying Out the Invention

Figs.1 and 2 are respectively a partial sectional view and partial plan view of a tape carrier according to a first embodiment of the present invention. In accordance with the present embodiment, a copper film of 0.2 $\mu$m is deposited by a spatter evaporation process on one surface of a flexible tape 2 composed of a polimide film of 50 $\mu$m thick and electrolytic copper plating is further applied, thus forming a copper foil layer of 10 $\mu$m thick.

Then, the copper foil layer is etched by using an aqueous solution of ferric chloride thereby forming a plurality of metal wiring which are arranged at a given pitch in the longitudinal direction and each having a wiring conductor width (at A in Fig.2) of 25 $\mu$m and a wiring conductor pitch (at B in Fig.2) of 50 $\mu$m. It is to be noted that in Fig.2 only one of the metal wiring portions are shown and the conductors are also shown partly.

In this embodiment, the wiring conductors of the metal wiring 1 is arranged radially as shown in Fig.2 so that inner lead portions 1a each adapted to be bonded to one of bumps 7 of a semiconductor device chip 6 are arranged on the inner side and outer lead portions 1b adapted to be connected to the terminals of a package or external circuit board are arranged on the outer side.

While, in the metal wiring 1 of this embodiment, the outer lead portions 1b having one-to-one correspondence to the inner lead portions 1a are provided and each of the outer lead portions 1b is adapted for connection with one of the terminals of an external circuit assembly such as a circuit board, the invention is not limited thereto.

In other words, the metal wiring formed on the tape carrier according to the present invention include not only

- 13 -

the case in which the wiring conductors each having the inner lead portion at one end and the outer lead portion at the other end are arranged at the given pitch but also other cases where there is the one-to-plural correspondence between the outer lead portions and the inner lead portions or where the inner lead portions are connected to given circuits formed on the outer side thereof. Further, while, in the present embodiment, each metal wiring is formed with only one group of inner lead poritons to which a semiconductor device chip is bonded, each metal wiring may be formed with a plurality of groups of inner lead portions as occasion demands.

Thereafter, excluding the portion of the back surface (the surface on which the metal wiring is not formed) of the flexible tape 2 which is enclosed by the broken line in Fig.2 (a first region including the inner lead portions 1a of the metal wiring 1 and surrounding the mounting region of the semiconductor device chip 6), the whole surface of the flexible tape 2 is protected with an alkaline-proof etching resist and this tape 2 is immersed in a 5-normal aqueous solution of potassium hydroxide for 1 hour at $50^{\circ}C$ thereby washing it in water. As a result, in the portion unprotected by the etching resist the remaining polyimide thickness is reduced to $9\mu m$. In other words, in the present embodiment the region of the flexible tape 2, including the inner lead portions 1a and surrounding the mounting region of the chip 6, is reduced in thickness from the back surface of the tape 2 (the back side of the paper

- 14 -

plane) by wet etching, thereby forming a thin-film portion 3 (the portion enclosed by the broken line in Fig.2).

It is to be noted that sprocket holes 5 which are successively formed at a given pitch longitudinally on each lateral side of the tape 2 and an outer lead opening 4 formed in the portion corresponding to the outer lead portions 1b are not always needed.

For instance, there are cases where the tape can be transported without using the sprockets holes 5 and where the outer lead portions 1b, with the flexible tape attached thereto, are bonded to the terminals of a circuit board or the like. Where such holes and opening must be formed, however, they can be formed by for example protecting the tape excluding those portions to be opened with an alkaline-proof etching regist and then etching the tape with the same alkaline-type solution as used for forming the thin-film portion.

Also, the portion corresponding to the outer lead opening 4 may be formed with a thin-film portion as in the case of the inner lead portions 1a, thereby making finer the metal wiring at the outer lead portions 1b, maintaining the required strength for the connecting leads to the terminals of an external circuit assembly and ensuring a high degree of bonding processability despite the finer wiring.

While, in this embodiment, Novax, the trade name of Mitsubishi Kasei Kogyo Co.,Ltd., is used for the flexible film member, the reason is that it is excellent in resistance to etching as mentioned previously and also it is semitransparent thus making it easy to effect image processing, etc., for registration purposes during the bonding.

Therefore, if any other product is used for the flexible film member, the etching conditions, etc., must be changed.

With the tape carrier manufactured in the manner described above, as shown by the enlarged sectional view of the inner lead portions and the surroundings of Fig.1, bumps 7 of the semiconductor device chip 6 were bonded to the inner lead portions 1a with the result that the inner lead portions 1a were supported by the thin-film portion 3 of the flexible tape 2 and thus there was no danger of the inner lead portions 1a being folded down by the application of pressure. Also, the thin-film portion 3 was as thin as $9 \mu m$ so that there was no danger of the inner lead portions being deformed by thermal stresses and the bonding processability was extremely excellent.

While, in this embodiment of the invention, the semiconductor device chips 6 are positioned on one side of the tape surface on which side the metal wiring 1 is formed, the invention is not limited thereto. For instance, by using for example the method of forming through-holes leading from the back side of the thin-film portion 3 to the metal wiring 1 providing the inner lead portions and inserting into the through-holes protruding electrodes or the like consisting of conductors which are extended from the metal wiring, thereby arranging the semiconductor device chip 6 on the back side of the thin-film portion.

Next, a second embodiment of the present invention will be described.

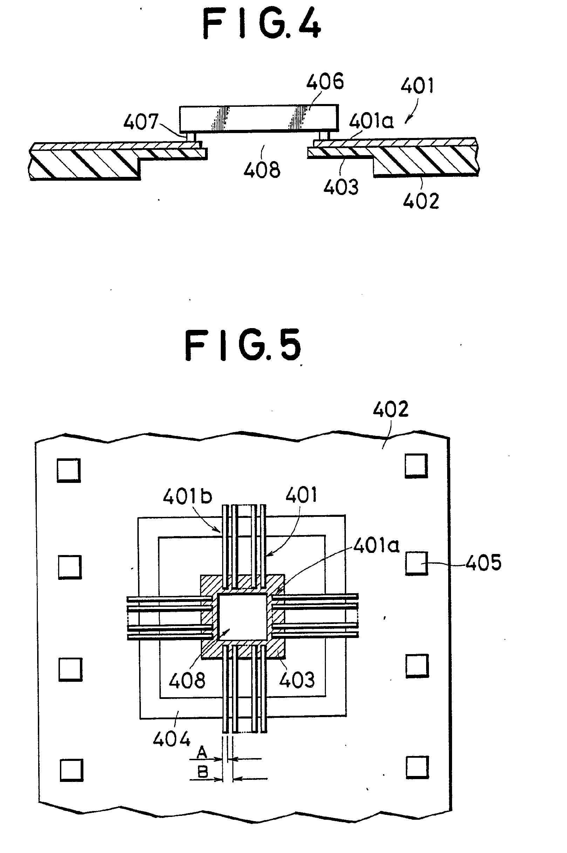

Figs.4 and 5 are respectively a partial sectional view and partial plan view of a tape carrier according to a second embodiment of the present invention. In the present embodiment, the forming method of a flexible tape 402 and its surface, the forming method of a metal wiring 401, etc., are almost the same with those of the previously mentioned first embodiment, and the metal wiring 401 is arranged as shown in Fig.5 so that inner lead portions 401a adapted to be bonded to bumps 407 of a semiconductor device chip 406 are arranged on the inner side and outer lead portions 401b adapted for connection to the terminals of a package or circuit board are arranged on the outer side.

It is to be noted that with the metal wiring 401 of the present embodiment, there exist the same relationships as the previously mentioned embodiment between the inner lead portions and the corresponding outer lead portions 401b.

Then, excluding a region surrounded by the inner lead portions 401a and located on the inner side by 1mm from the forward ends of the inner lead portions 401a (a region A), the whole surface of the flexible tape 402 is protected with an alkaline-proof etching resist and, after the tape 402 has been immersed in a 5-N aqueous solution of potassium hydroxide for 1.5 hours at $50^{O}C$, it is washed by water. As a result, the polyimide in the region A unprotected by the etching resist is removed thereby forming a device hole 408.

- 17 -

Thereafter, excluding a region B (indicated by the hatched portion in Fig.5) including the inner lead portions 401a and the mounting region of the semiconductor device chip 406, the surface of the flexible tape 402 is protected with an alkaline-proof etching resist and the tape 402 is immersed in a 5-N aqueous solution of potassium hydroxide for 1 hour at 50°C thereby washing it in water. As a result, in a region B which is a portion reinforcing the inner lead portions, the flexible tape 402 is subjected to half etching as shown in Fig.4 and a thin-film portion 403 is formed. In the present embodiment, the thickness (controlled by the etching conditions) of the thin-film portion 403 is selected 12$\mu$m.

In Fig.5, sprocket holes 405 formed successively at a given pitch longitudinally along each side of the tape and an outer lead opening 404 formed in the portion corresponding to the outer lead portions 401b are the same as in the case of the previously mentioned embodiment.

With the tape carrier manufactured in the above-mentioned manner, as shown by the enlarged sectional view of the device hole 408 and the surroundings of Fig.4, the inner lead portions 1a were bonded to the bumps 407 of the semiconductor device chip 406 with the result that the inner lead portions 401a were not folded down under the application of pressure due to the inner lead portions 1a being reinforced by the thin-film portion 403 of the flexible tape 402 in the region B.

Also, practically there was no deformation of the inner lead portions 401a due to thermal stresses and the bonding processability was extremely excellent.

In addidion, the present embodiment is advantageous in that since the device hole 408 is formed, when performing the resin molding at the product stage, a bonding molding resin can be introduced by utilizing the device hole 408 and thus the operation can be performed easily.

It is to be noted that while, in the above-described embodiment, the metal wiring of copper is formed, the metal wiring of the present invention is not limited to copper and it is needless to say that the metal wiring may be of a two-layer structure of copper and other metal or it may be made of only any other metal than copper.

Then, as regards the method of forming the thin-film portion in the first region, the following methods may be used in addition to the previously mentioned methods.

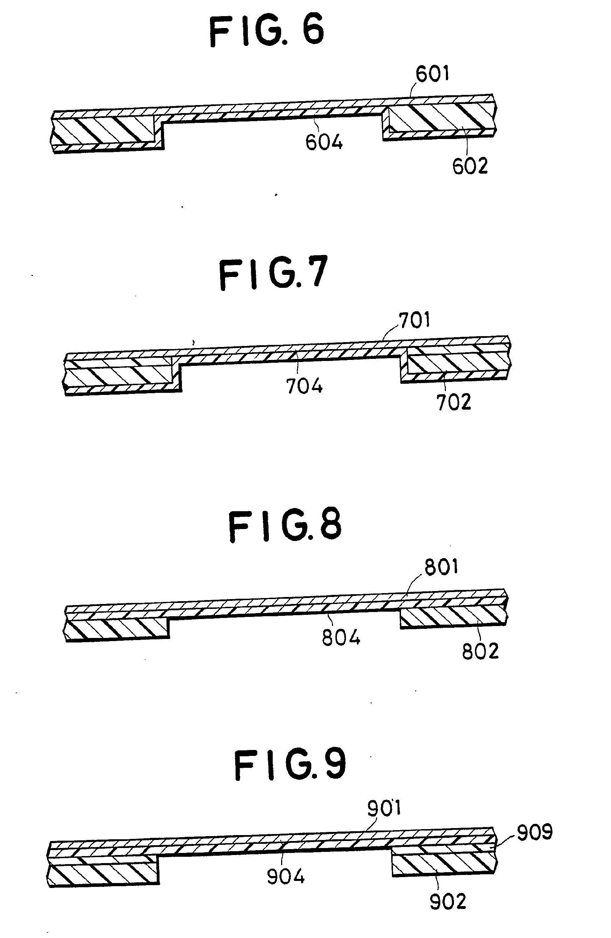

First, when subjecting a first region of a flexible film member 602 to an etching process, there are cases where it is difficult to form a thin film having a minute thickness by the half etching and therefore the flexible film member 6 of the first region may be removed entirely by etching or other method thereby forming a new thin film in the first region as shown in Fig.6. Also, as shown in Fig.7, instead of forming a layer of metal foil on a flexible film member 702, a strip of metal foil 701 of the same thickness as mentioned previously may be applied. In this case, while the flexible film member 702 may be subjected to the same etching process as mentioned previously, it is possible to use one having preliminarily an opening in a region corresponding to the first region or the device hole (region A).

It is only necessary to form a thin film 704 on the back side portion of the metal foil strip 701 in the opening. The material for the thin film 704 should preferably be one having the same properties as the flexible film member.

As the method of forming the thin-film portions 604 and 704, they may be formed easily by the method of applying a resin to for example only the opening or the whole surface to form a thin film.

On the other hand, if the thin-film forming material has adhesive properties, as shown in Fig.8, a thin-film portion 804 can be easily formed at the opening in such a manner that when applying the metal foil strip 801, its whole application surface is laminated with the thin-film forming material and it is applied as such.

For instance, if the material is a curable material of the epoxy, polyimide or polyester type, not only it serves as a flexible film member but also it has adhesive properties so that it can form a thin-film portion and . simultaneously it can be diverted to serve as an adhesive bond.

Also, where the thin-film forming material does not have adhesive properties, as shown in Fig.9, a thin-film portion can be formed in a first region by forming a coating layer 904 over the whole surface on the side of a metal foil strip 901 and an adhesive bond 909 over the whole surface on the film member side.

In addition, a thin film may be formed through the combination of these methods and also it is possible to preliminarily prevent the application of the material to the portions requiring no thin film or it is possible to use a photosensitive material such as a photosensitive polyimide as the material for a thin-film portion such that the material is applied to a flexible film and then a thin film is left only on the desired portion by lithography.

Industrial Applicability

The present invention is mainly utilized in the course of manufacture of semiconductor devices employing semiconductor device chips.

CLAIMS

1. A chip carrier comprising a flexible film member formed on one surface thereof with a plurality of metal wiring each thereof including a plurality of inner lead portions adapted to be connected to terminal portion of a semiconductor device chip, each of said metal wiring being formed radially toward a region where each said chip is to be mounted, wherein:

said film member has a first thickness in a limited first region surrounding each said mounting region and including said inner lead portions and a second thickness in a second region surrounding said first region, said first thickness being thinner than said sacond thickness.

2. A chip carrier according to claim 1, wherein said film member is in the form of a flexible tape in which a plurality of regions each adapted for mounting a semiconductor device chip thereon is arranged, each said mounting region being provided with a metal wiring formed on one surface side of said flexible tape, each of said metal wiring including a plurality of inner lead portions adapted to be connected to the terminal portion of each said chip,

and wherein with respect to each said mounting region, said tape has in a limited first region including said inner lead portions and surrounding each said mounting region a relatively thin thickness as compared with a second region surrounding said first region.

3. A chip carrier according to claim 1 or 2, wherein said flexible film member includes an opening in a region on the inner side of forward ends of said inner lead portions within each said first region.

4. A chip carrier according to claim 1, 2 or 3, wherein each said first region of said film member is reduced in thickness on the side thereof opposite to said surface side where said metal wiring is formed.

5. A chip carrier according to claim 1, 2, 3 or 4, wherein each said metal wiring includes a plurality of outer lead portions adapted to be connected to external circuit means, and wherein said film member has a third thickness in a third region including said outer lead portions, said third thickness being thinner than said second thickness.

6. A combination comprising:

a chip carrier including a flexible film member formed on one surface side thereof with a plurality of metal wiring each radially extending toward one of a plurality of regions for mounting a semiconductor device chip, each of said metal wiring including plurality of inner lead portions adapted to be connected to terminal portion of said device chip; and

said semiconductor device chip mounted on each of said mounting regions of said carrier and having the terminal portions thereof electridcally connected to said inner lead portions of each said metal wiring,

wherein said film member has a first thickness in a plurality of limited first regions including said inner lead portions of each said metal wiring and surrounding each said mounting region and a second thickness in a plurality of second regions surrounding each said first region, said first thickness being thinner than said second thickness.

7. A combination according to claim 6, comprising:

said chip carrier wherein said film member is in the form of a flexible tape in which a plurality of semiconductor device chip mounting regions are arranged on said tape, and a plurality of metal wiring are each formed at one of said mounting regions on one surface side of said flexible tape, each said metal wiring including a plurality of inner lead portions adapted to be connected to the terminal portions of one of said chips; and

a plurality of semiconductor device chips each thereof being mounted on one of said mounting regions.

8. A combination according to claim 6 or 7, wherein said flexible film member is removed or is not preliminarily formed in a region on the inner side of forward ends of said inner lead portions within each said first region whereby an opening is formed in said inner side region.

9. A combination according to claim 6, 7 or 8, wherein each said first region of said film member of said chip carrier is reduced in thickness on an opposite side to said surface side where said metal wiring are formed.

10. A combination according to claim 6, 7, 8 or 9, wherein each said metal wiring of said chip carrier includes a plurality of outer lead portions adapted to be connected to terminal portions of exterminal circuit means, and wherein said film member has a third thickness in a third region including said outer lead portions, said third thickness being thinner than said second thickness.

# F I G.1

# F I G.2

# F I G.3

# FIG.4

# FIG.5

# FIG. 6

601

604

602

# FIG.7

701

704

702

# FIG.8

801

804

802

# FIG.9

901

909

904

902

# INTERNATIONAL SEARCH REPORT

International Application No PCT/JP90/00138

## I. CLASSIFICATION OF SUBJECT MATTER (if several classification symbols apply, indicate all) [6]

According to International Patent Classification (IPC) or to both National Classification and IPC

Int. Cl$^5$ H01L21/60

## II. FIELDS SEARCHED

### Minimum Documentation Searched [7]

| Classification System | Classification Symbols |
|---|---|
| IPC | H01L21/60 |

### Documentation Searched other than Minimum Documentation to the Extent that such Documents are Included in the Fields Searched [8]

| | |
|---|---|
| Jitsuyo Shinan Koho | 1962 - 1990 |
| Kokai Jitsuyo Shinan Koho | 1971 - 1990 |

## III. DOCUMENTS CONSIDERED TO BE RELEVANT [9]

| Category [*] | Citation of Document, [11] with indication, where appropriate, of the relevant passages [12] | Relevant to Claim No. [13] |
|---|---|---|
| A | JP, A, 55-143040 (Hitachi, Ltd.), 08 Nov. 1980 (08. 11. 80), Fig. 1 (Family: none) | 1 - 10 |
| A | JP, A, 63-12441 (Toshiba Corp.), 27 May 1988 (27. 05. 88), (Family: none) | 1 - 10 |
| X | JP, A, 62-199022 (Toshiba Corp.), 2 September 1987 (02. 09. 87), Fig. 1 (Family: none) | 1-4, 6-9 |

* Special categories of cited documents: [10]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search | Date of Mailing of this International Search Report |
|---|---|
| March 6, 1990 (06. 03. 90) | March 19, 1990 (19. 03. 90) |
| International Searching Authority | Signature of Authorized Officer |
| Japanese Patent Office | |

Form PCT/ISA/210 (second sheet) (January 1985)